# EUROPEAN PATENT APPLICATION

(11) **EP 4 560 696 A1**
(43) Date of publication of application: **28.05.2025**
(21) Application number: 24214236.2
(22) Date of filing: 20.11.2024
(51) Int. Cl.: H01L 23/31, H01L 23/433, H01L 25/07, H01L 23/373

(54) **POWER MODULE, MANUFACTURING METHOD, AND ELECTRONIC DEVICE**

(30) Priority: 24.11.2023 CN 202311594513
(71) Applicant: Huawei Digital Power Technologies Co., Ltd., Shenzhen, Guangdong 518043 (CN)
(72) Inventor: ZHU, Gaojie, Shenzhen, 518043 (CN); WU, Fankun, Shenzhen, 518043 (CN); QIAO, Yunfei, Shenzhen, 518043 (CN)
(74) Representative: Gill Jennings & Every LLP

(57) **Abstract**

This application provides a power module, a manufacturing method, and an electronic device. The power module includes a heat dissipation panel, a substrate, and a chip that are sequentially stacked. A first region and a second region are disposed on a surface of the heat dissipation panel, the second region is disposed at least at a corner of the first region, and surface roughness of the second region is greater than surface roughness of the first region. A projection of the substrate in a thickness direction of the heat dissipation panel overlaps the first region. A third region is disposed on a surface that is of the substrate and that is away from the heat dissipation panel, and a projection of the chip in the thickness direction of the heat dissipation panel overlaps the third region. The substrate and the chip are packaged by using a molding compound, and the second region is in contact with the molding compound. Therefore, when the surface roughness of the second region is large, a bonding area between the molding compound and the heat dissipation panel can be increased, and strength of bonding between the molding compound and the heat dissipation panel can be enhanced, to avoid delamination of bonding surfaces, and improve a molding effect.

## Description

### TECHNICAL FIELD

This application relates to the field of electronic technologies, and in particular, to a power module, a manufacturing method, and an electronic device.

### BACKGROUND

As a power module and the like in an electronic device evolve toward high power density and high reliability, the power module and the like may be packaged in a three-dimensional (3D) molding manner. This improves heat dissipation performance, power density, reliability, and the like of the power module in the electronic device.

When the power module is packaged, a chip is soldered to a substrate like a direct bonded copper (DBC) substrate, then the substrate is soldered to a heat sink or a heat dissipation panel, and finally the heat sink or the heat dissipation panel is packaged by using a molding compound. During packaging, strength of bonding between the molding compound and the heat sink or the heat dissipation panel and strength of bonding between the molding compound and the substrate need to be considered, to avoid delamination of bonding surfaces, and improve a molding effect.

In view of this, how to improve a molding effect is an urgent problem to be solved.

### SUMMARY

This application provides a power module, a manufacturing method, and an electronic device, to improve a molding effect.

According to a first aspect, an embodiment of this application provides a power module. The power module includes a heat dissipation panel, a substrate, and a chip that are sequentially stacked. A first region and a second region are disposed on a surface of the heat dissipation panel, the second region is disposed at least at a corner of the first region, and surface roughness of the second region is greater than surface roughness of the first region. A projection of the substrate in a thickness direction of the heat dissipation panel overlaps the first region. A third region is disposed on a surface that is of the substrate and that is away from the heat dissipation panel, and a projection of the chip in the thickness direction of the heat dissipation panel overlaps the third region. The substrate and the chip are packaged by using a molding compound, and the second region is in contact with the molding compound. In addition, first solder is disposed in the first region, the substrate is fastened to the heat dissipation panel by using the first solder, second solder is disposed in the third region, and the chip is fastened to the substrate by using the second solder. Therefore, when the surface roughness of the second region is greater than the surface roughness of the first region, a bonding area between the molding compound and the second region of the heat dissipation panel can be increased, and strength of bonding between the molding compound and the heat dissipation panel can be enhanced, to avoid delamination of bonding surfaces, and improve a molding effect.

Optionally, the first region and the second region may be further disposed in at least one of the following manners.

In a first manner, the second region encloses at least a part of the first region. In this way, an area of the second region can be increased, and an area of bonding with the molding compound can be increased, to enhance molding strength. In addition, when the second region has a solder resist function, the second region may perform the solder resist function on the first solder in the first region, to prevent the first solder from overflowing the first region, and avoid impact on another structure while improving a soldering effect. In addition, the substrate can be further fastened, to avoid deviation of the substrate during soldering.

In a second manner, a plurality of first regions are disposed, and at least parts of second regions corresponding to two adjacent first regions are connected. In this way, the area of the second region on the surface of the heat dissipation panel can be increased, and the bonding area between the molding compound and the second region can be increased, to enhance molding strength and improve a molding effect. One, two, or more first regions may be disposed. A specific quantity of first regions may be set based on an actual requirement. This is not limited herein.

In a third manner, a region, except the first region, on the surface of the heat dissipation panel is the second region, in other words, there is only the second region on the surface of the heat dissipation panel except the first region. In this way, the area of the second region can be increased to a greatest extent, and an area of contact with the molding compound can be further increased, to further enhance molding strength.

In a fourth manner, the second region overlaps an orthographic projection of the substrate on the heat dissipation panel. In this way, flexibility for disposing the second region can be improved, and flexibility for designing the power module can be improved.

In a fifth manner, the orthographic projection of the substrate on the heat dissipation panel is located in the first region, and an area of the first region is greater than an area of the orthographic projection of the substrate on the heat dissipation panel, so that the area of the first region is larger, and the area of the orthographic projection of the substrate on the heat dissipation panel is smaller. In this way, because the first solder is generally coated on a region soldered to the substrate, and does not cover the entire first region, the first solder in the first region with a large area is difficult to overflow, to avoid impact on strength of bonding between the molding compound and the second region when the first solder overflows to the second region. Therefore, molding strength can be further enhanced.

In a sixth manner, the first region is located in the orthographic projection of the substrate on the heat dissipation panel, and an area of the orthographic projection of the substrate on the heat dissipation panel is greater than an area of the first region, so that the area of the orthographic projection of the substrate on the heat dissipation panel is larger, and the area of the first region is smaller In this case, there is a gap between the second region and the corresponding first region. A size of the gap may be set based on an actual requirement. This is not limited herein. In this way, when the first solder is coated on the first region, even if the first solder overflows, because there is a part of region (namely, a region corresponding to the gap) that is different from the first region and that is between the substrate and the heat dissipation panel, the region may be used as an overflow region, to prevent the first solder from overflowing to the second region, and avoid impact on the strength of bonding between the molding compound and the second region when the first solder overflows to the second region. Therefore, molding strength can be further enhanced.

It should be understood that a shape of the second region may be set based on an actual situation provided that the foregoing position relationship can be met. This is not limited herein.

Optionally, the second region may conform to the following settings.

Setting 1: A concave-convex structure is disposed on the second region, and the concave-convex structure may be at least one of the following structures: a fin structure, a concave structure, and a convex structure. A specific combination manner may be set based on an actual requirement. This is not limited herein. In addition, specific shapes and disposing density of each fin, pit, and protrusion in the fin structure may be set based on an actual requirement. This is not limited herein. In this way, the concave-convex structure is disposed in the delimited second region, so that the bonding area that is between the molding compound and the heat dissipation panel and that is in the second region can be further increased, and the strength of bonding between the molding compound and the heat dissipation panel can be further enhanced, to further improve a molding effect.

Setting 2: A forming material of the second region is different from a forming material of the first region, so that the second region can be used as a solder resist layer to perform the solder resist function on the first solder in the first region, to prevent the first solder from overflowing the first region, and avoid impact on another structure while improving a soldering effect. In addition, the substrate can be further fastened, to avoid deviation of the substrate during soldering.

Setting 3: The second region is formed through sandblasting, in other words, the delimited second region is bombarded in a sandblasting manner, to increase the surface roughness of the second region. In this way, the second region may have high surface roughness, to improve a molding effect.

Setting 4: A manufacturing material of a surface that is of the heat dissipation panel and that is soldered to the substrate includes copper elements. In this case, the heat dissipation panel may be referred to as a bare copper setting. The surface that is of the heat dissipation panel and that is soldered to the substrate may also be referred to as a soldering surface of the heat dissipation panel, in other words, a manufacturing material of the soldering surface of the heat dissipation panel includes copper elements. For example, the manufacturing material of the soldering surface of the heat dissipation panel may be monatomic copper. In this case, the heat dissipation panel may be a copper plate, or a plate whose soldering surface is plated with monatomic copper. Alternatively, the manufacturing material of the soldering surface of the heat dissipation panel may be copper oxide. In this case, the heat dissipation panel may be a copper oxide plate, or a plate whose soldering surface is plated with copper oxide. Alternatively, the manufacturing material of the soldering surface of the heat dissipation panel may be a copper alloy. In this case, the heat dissipation panel may be a copper alloy plate, or a plate whose soldering surface is plated with a copper alloy. For example, the heat dissipation panel is a copper plate. After the copper plate is manufactured, surface roughness of different regions on a surface of the copper plate is different. Therefore, the first region and the second region may be delimited based on the surface roughness of the surface of the copper plate, so that the surface roughness of the delimited second region is greater than the surface roughness of the delimited first region.

It should be understood that a structure of the second region may alternatively use a combination of the foregoing plurality of settings, for example, a setting manner of combining bare copper and local sandblasting, a setting manner of combining bare copper and a locally disposed concave-convex structure, a setting manner of combining different forming materials and a locally disposed concave-convex structure, or the like. Examples are not enumerated one by one.

Optionally, a fourth region disposed at least at a corner of the third region may be further disposed on a second surface of the substrate, where surface roughness of the fourth region is greater than surface roughness of the third region, and the fourth region is in contact with the molding compound. In this way, a bonding area between the molding compound and the fourth region of the substrate can be increased, and strength of bonding between the molding compound and the substrate can be enhanced, to avoid delamination of bonding surfaces, and further improve a molding effect.

The third region and the fourth region may be disposed in at least one of the following manners.

In a first manner, the fourth region encloses at least a part of the third region. In this way, an area of the fourth region can be increased, and an area of bonding with the molding compound can be increased, to enhance molding strength. In addition, when the fourth region has a solder resist function, the fourth region may perform the solder resist function on the second solder in the third region, to prevent the second solder from overflowing the third region. This avoids impact on another structure while improving a soldering effect. In addition, the chip can be further fastened, to avoid deviation of the chip during soldering.

In a second manner, a region, except the third region, on the surface that is of the substrate and that is away from the heat dissipation panel is the fourth region. In this way, the area of the fourth region can be increased to a greatest extent, and an area of contact with the molding compound can be further increased, to further enhance molding strength.

In a third manner, an orthographic projection of the chip on the substrate is located in the third region, and an area of the third region is greater than an area of the orthographic projection of the chip on the substrate. In this way, because the second solder is generally coated on a region soldered to the chip, and does not cover the entire third region, the second solder in the third region with a large area is difficult to overflow, to avoid impact on strength of bonding between the molding compound and the fourth region when the second solder overflows to the fourth region. Therefore, molding strength can be further enhanced.

In a fourth manner, the third region is located in the orthographic projection of the chip on the substrate, and the area of the orthographic projection of the chip on the substrate is greater than the area of the third region. In this case, there is a gap between the fourth region and the corresponding third region. A size of the gap may be set based on an actual requirement. This is not limited herein. In this way, when the second solder is coated on the third region, even if the second solder overflows, because there is a part of region (namely, a region corresponding to the gap) that is different from the third region and that is between the chip and the substrate, the region may be used as an overflow region, to prevent the second solder from overflowing to the fourth region, and avoid impact on the strength of bonding between the molding compound and the fourth region when the second solder overflows to the fourth region. Therefore, molding strength can be further enhanced.

It should be understood that a shape of the fourth region may be set based on an actual situation provided that the foregoing position relationship can be met. This is not limited herein.

In addition, the fourth region may conform to the following settings.

Setting 1: A forming material of the fourth region is different from a forming material of the third region, so that the fourth region can be used as a solder resist layer to perform the solder resist function on the second solder in the third region, to prevent the second solder from overflowing the third region, and avoid impact on another structure while improving a soldering effect. In addition, the chip can be further fastened, to avoid deviation of the chip during soldering.

Setting 2: The fourth region may be formed through sandblasting, in other words, the delimited fourth region is bombarded in a sandblasting manner, to increase the surface roughness of the fourth region. In this way, the fourth region may have high surface roughness, to improve a molding effect.

It should be understood that, for settings of the fourth region, any one of the foregoing settings may be used, or a combination of the foregoing settings may be used, so that a bonding area that is between the molding compound and the heat dissipation panel and that is in the fourth region is further increased, and the strength of bonding between the molding compound and the heat dissipation panel is further enhanced, to further improve a molding effect.

According to a second aspect, an embodiment of this application further provides a power module manufacturing method. The manufacturing method is used to manufacture the power module described in the first aspect or any embodiment of the first aspect. The manufacturing method may include: forming a second region at least at a corner of a first region on a surface of a heat dissipation panel, where surface roughness of the second region is greater than surface roughness of the first region; fastening a substrate to the heat dissipation panel by using the first region, and fastening a chip to the substrate by using a third region, so that a projection of the substrate in a thickness direction of the heat dissipation panel overlaps the first region, and a projection of the chip in the thickness direction of the heat dissipation panel overlaps the third region; and packaging the substrate and the chip by using a molding compound, so that the second region is in contact with the molding compound, to obtain the power module. In this way, when the surface roughness of the second region is greater than the surface roughness of the first region, a bonding area between the molding compound and the second region of the heat dissipation panel can be increased, and strength of bonding between the molding compound and the heat dissipation panel can be enhanced, to avoid delamination of bonding surfaces, and improve a molding effect.

Optionally, when the second region is formed, at least one of the following manners may be used: a laser ablation manner, a mold pressing manner, a sandblasting manner, or a manner of manufacturing a concave-convex structure.

For laser ablation, a working principle of the laser ablation is as follows: The delimited second region is irradiated by using a laser, so that a series of physical phenomena such as a temperature rise, instant melting or even vaporization, and ionization mixed steam occur on a surface layer material of the second region, thereby leaving a permanent burn mark. Therefore, after the laser ablation is used, a forming material of the second region is different from a forming material of the first region, so that the second region can be used as a solder resist layer to perform the solder resist function on the first solder in the first region, to prevent the first solder from overflowing the first region, and avoid impact on another structure while improving a soldering effect. In addition, the substrate can be further fastened, to avoid deviation of the substrate during soldering.

For mold pressing, the delimited second region is pressed by using a mold with a pattern, to increase the surface roughness of the second region. This manner is easy to operate and easy to implement, and can reduce manufacturing costs of the power module while improving a molding effect. During the mold pressing, the pattern in the mold may be mesh-shaped, triangle-shaped, quadrilateral-shaped, irregular-shaped, or the like, and may be designed based on an actual requirement. In addition, a pressing depth of the mold is not specifically required.

For sandblasting, a working principle of the sandblasting is as follows: Sand is sprayed to the surface of the heat dissipation panel, and the surface of the heat dissipation panel is bombarded by using the sand, to form the second region. Therefore, during the sandblasting, the surface roughness of the second region may be controlled by selecting a size of the sand, to meet a molding requirement. Further, the size of the sand may be selected based on a requirement for the surface roughness of the second region. This is not limited herein. In addition, a manufacturing material of a soldering surface of the heat dissipation panel includes copper elements. For example, the manufacturing material of the soldering surface of the heat dissipation panel may be monatomic copper. In this case, the heat dissipation panel may be a copper plate, or a plate whose soldering surface is plated with monatomic copper. Alternatively, the manufacturing material of the soldering surface of the heat dissipation panel may be copper oxide. In this case, the heat dissipation panel may be a copper oxide plate, or a plate whose soldering surface is plated with copper oxide. Alternatively, the manufacturing material of the soldering surface of the heat dissipation panel may be a copper alloy. In this case, the heat dissipation panel may be a copper alloy plate, or a plate whose soldering surface is plated with a copper alloy. In this way, the second region is formed in a manner of combining bare copper and local sandblasting. This manner is easy to operate and easy to implement, and can reduce manufacturing costs of the power module while improving a molding effect.

For manufacturing a concave-convex structure, the concave-convex structure may be at least one of the following structures: a fin structure, a concave structure, and a convex structure. A specific combination manner may be set based on an actual requirement. This is not limited herein. In addition, specific shapes and disposing density of each fin, pit, and protrusion in the fin structure may be set based on an actual requirement. This is not limited herein.

Certainly, for example, the heat dissipation panel is a copper plate. After the copper plate is manufactured, surface roughness of different regions on a surface of the copper plate is different. Therefore, the first region and the second region may be delimited based on the surface roughness of the surface of the copper plate, so that the surface roughness of the delimited second region is greater than the surface roughness of the delimited first region. Compared with using a copper plate whose surface is plated with nickel as the heat dissipation panel, in a manner of using the copper plate as the heat dissipation panel, the first region and the second region may be obtained without performing any processing on the surface of the copper plate. In this manner, manufacturing costs can be greatly reduced, production capacity can be improved, and a nickel plating process can be reduced.

In addition, a specific value of the surface roughness of the second region may be set based on a requirement for molding. For example, if the requirement for molding is high, the surface roughness of the second region may be set to a larger value. If the requirement for molding is low, the surface roughness of the second region may be set to a smaller value.

Optionally, the manufacturing method further includes: before fastening the chip to the substrate by using the third region, forming a fourth region at least at a corner of the third region, where surface roughness of the fourth region is greater than surface roughness of the third region. In this way, a bonding area between the molding compound and the fourth region of the substrate can be increased, and strength of bonding between the molding compound and the substrate can be enhanced, to avoid delamination of bonding surfaces, and further improve a molding effect.

When the fourth region is formed, at least one of the following manners may be used: a laser ablation manner, a mold pressing manner, and a sandblasting manner, where specific implementations of the laser ablation, the mold pressing, and the sandblasting are the same as specific implementations of corresponding manners in which the second region is formed. For details, refer to related descriptions in which the second region is formed. Repeated content is not described again.

It should be understood that, a problem-resolving principle of the power module manufactured by using the manufacturing method is similar to a problem-resolving principle of the foregoing power module. Therefore, for implementation and technical effects of the manufacturing method, refer to the implementation and technical effects of the foregoing power module. Repeated content is not described again.

According to a third aspect, an embodiment of this application further provides an electronic device. The electronic device includes a housing and the power module described in the first aspect and any embodiment of the first aspect. The power module is disposed in the housing. This can improve reliability of the electronic device and security of use while improving a molding effect of the power module.

A problem-resolving principle of the electronic device is similar to a problem-resolving principle of the foregoing power module. Therefore, for implementation and technical effects of the electronic device, refer to the implementation and technical effects of the foregoing power module. Repeated content is not described again.

### BRIEF DESCRIPTION OF DRAWINGS

FIG. 1 is a diagram of a structure of an electronic device according to an embodiment of this application;
FIG. 2 is a diagram of a structure of a power module according to an embodiment of this application;
FIG. 3 is a diagram of a position relationship between a first region and a second region according to an embodiment of this application;
FIG. 4 is a diagram of another position relationship between a first region and a second region according to an embodiment of this application;
FIG. 5 is a diagram of still another position relationship between a first region and a second region according to an embodiment of this application;
FIG. 6 is a diagram of yet another position relationship between a first region and a second region according to an embodiment of this application;
FIG. 7 is a diagram of still yet another position relationship between a first region and a second region according to an embodiment of this application;
FIG. 8 is a diagram of a further position relationship between a first region and a second region according to an embodiment of this application;
FIG. 9 is a diagram of a position relationship between a third region and a fourth region according to an embodiment of this application;
FIG. 10 is a diagram of another position relationship between a third region and a fourth region according to an embodiment of this application;
FIG. 11 is a diagram of still another position relationship between a third region and a fourth region according to an embodiment of this application;
FIG. 12 is a flowchart of a power module manufacturing method according to an embodiment of this application; and
FIG. 13 is a flowchart of another power module manufacturing method according to an embodiment of this application.

### DESCRIPTION OF EMBODIMENTS

To make the objectives, technical solutions, and advantages of this application clearer, the following further describes this application in detail with reference to the accompanying drawings.

It should be noted that same reference numerals in the accompanying drawings of this application represent same or similar structures, and therefore repeated descriptions thereof are omitted. Expressions of positions and directions in this application are described by using the accompanying drawings as an example. However, changes may also be made as required, and all the changes fall within the protection scope of this application. The accompanying drawings of this application are merely used to illustrate relative position relationships and do not represent a real proportion.

For ease of understanding the technical solutions provided in embodiments of this application, the following first describes application scenarios of the technical solutions.

The power module provided in embodiments of this application may be widely used in various electronic devices. The electronic device provided in embodiments of this application may include various terminal devices and electronic components. The terminal device may include but is not limited to devices such as a smartphone, a smart TV, a smart TV set-top box, a smartwatch, a personal computer (PC), a wearable device, and an intelligent broadband device. The electronic component may include but is not limited to an inverter in a photovoltaic power generation system. Examples are not enumerated one by one herein.

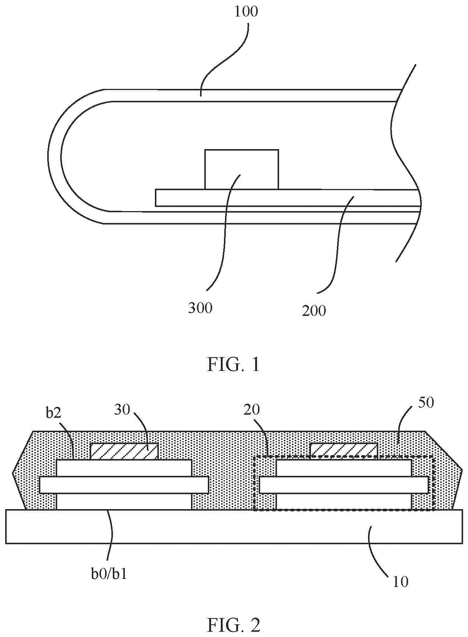

FIG. 1 is an example of a diagram of a structure in which a power module is used in an electronic device. Refer to FIG. 1. The electronic device includes a housing 100 and a circuit board 200 disposed in the housing 100. A power module 300 is disposed on the circuit board 200. For example, the electronic device is an inverter. The inverter is a core device in a photovoltaic power generation system, and a main function of the inverter includes converting a direct current generated by a photovoltaic module into an alternating current and then outputting the alternating current. A power device is an important component of the inverter, and plays a role of power conversion and energy transmission in the inverter. The power module 300 is one of power devices.

When the power module 300 is formed, a chip is soldered to a substrate (the substrate may be a direct bonded copper substrate), then the substrate is soldered to a heat sink or a heat dissipation panel, and finally the heat sink or the heat dissipation panel is packaged by using a molding compound, to form the power module 300. During packaging, strength of bonding between the molding compound and the heat sink or the heat dissipation panel and strength of bonding between the molding compound and the substrate need to be considered, to avoid delamination of bonding surfaces, and improve a molding effect.

In view of this, this application provides a power module, a manufacturing method, and an electronic device, to improve a molding effect. The following describes in detail a specific structure and construction of the power module with reference to specific embodiments.

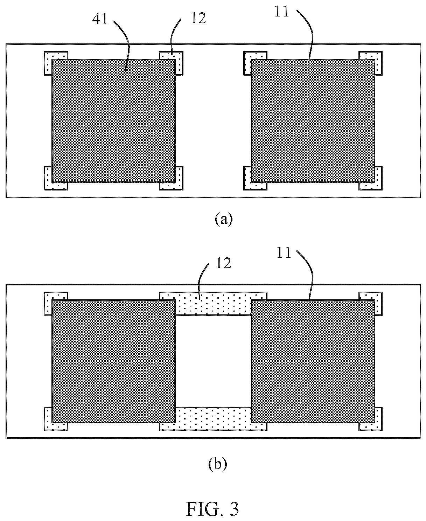

FIG. 2 to FIG. 8 are examples of diagrams of structures of a power module according to this application. As shown in FIG. 2, the power module may include a heat dissipation panel 10, a substrate 20 disposed on the heat dissipation panel 10, and a chip 30 disposed on the substrate 20. The substrate 20 may be a direct bonded copper substrate. In other words, copper layers are disposed on an upper side and a lower side of a ceramic plate, to form a three-layer stacked structure. As shown in FIG. 3 to FIG. 8, a first region 11 and a second region 12 disposed at least at a corner of the first region 11 are disposed on a surface of the heat dissipation panel 10 (namely, a soldering surface b0 of the heat dissipation panel 10), where surface roughness of the second region 12 is greater than surface roughness of the first region 11; and first solder 41 is disposed in the first region 11. The substrate 20 has a first surface b1 and a second surface b2 that are disposed opposite to each other. The first surface b1 of the substrate 20 is fastened to the heat dissipation panel 10 by using the first solder 41, a third region (not shown in FIG. 2 to FIG. 8) is disposed on the second surface b2 of the substrate 20, second solder (not shown in FIG. 2 to FIG. 8) is disposed in the third region, and the chip 30 is fastened to the second surface b2 by using the second solder. The substrate 20 and the chip 30 are packaged by using a molding compound 50, and the molding compound 50 is in contact with the second region 12. Therefore, when the surface roughness of the second region 12 is greater than the surface roughness of the first region 11, a bonding area between the molding compound 50 and the second region 12 of the heat dissipation panel 10 can be increased, and strength of bonding between the molding compound 50 and the heat dissipation panel 10 can be enhanced, to avoid delamination of bonding surfaces, and improve a molding effect. It should be understood that there may be one or at least two chips 30 disposed on the substrate 20. This may be specifically designed based on an actual situation, and is not limited herein. In addition, there may be one or at least two substrates 20 disposed on the heat dissipation panel 10. This may be specifically designed based on an actual situation, and is not limited herein.

A position relationship between the first region 11 and the second region 12 may include at least one of the following relationships.

As shown in FIG. 3, when the second region 12 is disposed at at least a part of corners of the first region 11, and a plurality of first regions 11 are disposed, second regions 12 located at corner positions of two adjacent first regions 11 may be connected, as shown in (b) in FIG. 3. In this way, an area of the second region 12 on the surface of the heat dissipation panel can be increased, and the bonding area between the molding compound and the second region 12 can be increased, to enhance molding strength. Certainly, the second regions 12 located at the corner positions of the two adjacent first regions 11 may be not connected, as shown in (a) in FIG. 3. In this way, a difficulty in manufacturing the second regions 12 can be reduced, and manufacturing costs of the power module can be reduced.

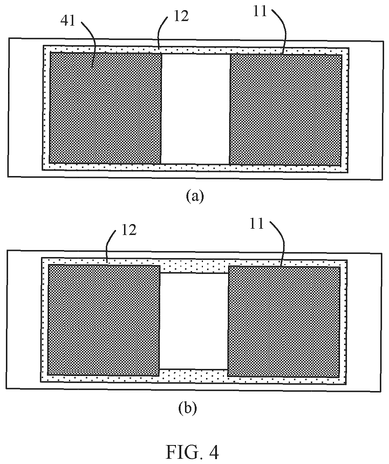

As shown in FIG. 4, when the second region 12 encloses a part of a peripheral region of the first region 11, and a plurality of first regions 11 are disposed, second regions 12 corresponding to two adjacent first regions 11 may be connected. In this way, the area of the second region 12 on the surface of the heat dissipation panel can be increased, and the bonding area between the molding compound and the second region 12 can be increased, to enhance molding strength. When the second regions 12 corresponding to the two adjacent first regions 11 are connected, as shown in (a) in FIG. 4, no second region 12 is disposed at a part of corner positions of the two first regions 11. Alternatively, as shown in (b) in FIG. 4, even when the second region 12 encloses a part of the peripheral region of the first region 11, the second region 12 is disposed at each corner position of the two first regions 11. Certainly, the second regions 12 corresponding to the two adjacent first regions 11 may be not connected. In this way, a difficulty in manufacturing the second regions 12 can be reduced, and manufacturing costs of the power module can be reduced.

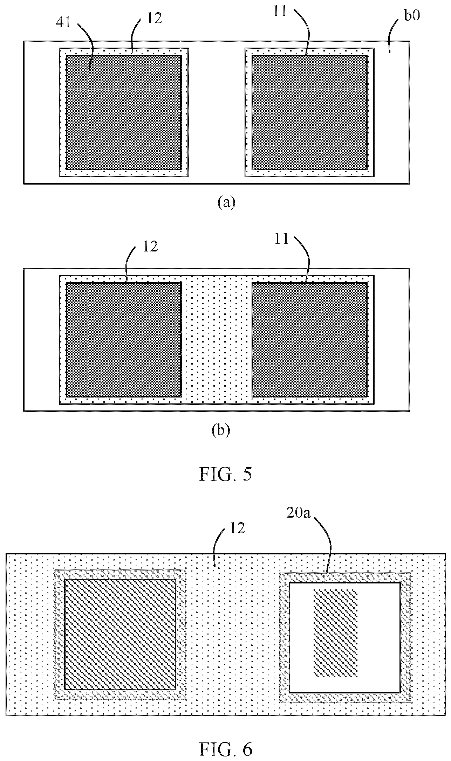

As shown in FIG. 5, the second region 12 completely encloses the peripheral region of the first region 11, and the second region 12 may be disposed in a part of a region except the first region 11 on the soldering surface b0, as shown in (a) in FIG. 5. Alternatively, the second region 12 may be disposed in the entire region except the first region 11 on the soldering surface b0, as shown in (b) in FIG. 5, in other words, the region except the first region 11 on the soldering surface b0 is the second region 12. In this way, the area of the second region 12 can be increased to a greatest extent, and an area of contact with the molding compound can be further increased, to further enhance molding strength.

As shown in FIG. 6, the second region 12 overlaps an orthographic projection 20a of the substrate 20 on the heat dissipation panel 10.

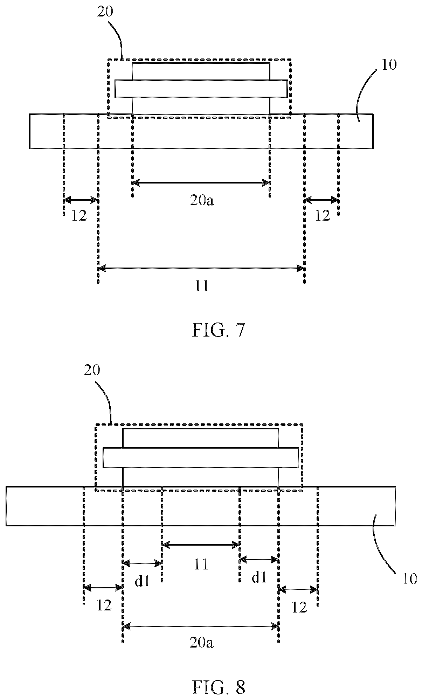

As shown in FIG. 7, the orthographic projection 20a of the substrate 20 on the heat dissipation panel 10 is located in the first region 11, and an area of the first region 11 is greater than an area of the orthographic projection 20a of the substrate 20 on the heat dissipation panel 10. In this way, because the first solder (not shown in FIG. 7) is generally coated on a region soldered to the substrate 20 (for example, a region indicated by 20a), and does not cover the entire first region 11, the first solder in the first region 11 with a large area is difficult to overflow, to avoid impact on strength of bonding between the molding compound and the second region 12 when the first solder overflows to the second region 12. Therefore, molding strength can be further enhanced.

As shown in FIG. 8, the first region 11 is located in the orthographic projection 20a of the substrate 20 on the heat dissipation panel 10, and the area of the orthographic projection 20a of the substrate 20 on the heat dissipation panel 10 is greater than the area of the first region 11. In this case, there is a gap d1 between the second region 12 and the corresponding first region 11. A size of the gap d1 may be set based on an actual requirement. The gap d1 is set to, for example, but not limited to, a distance between an edge of the first region 11 and a corresponding edge of the substrate 20. In this way, when the first solder (not shown in FIG. 8) is coated on the first region 11, even if the first solder overflows, because there is a part of region (namely, a region indicated by d1) that is different from the first region 11 and that is between the substrate 20 and the heat dissipation panel 10, the region may be used as an overflow region, to prevent the first solder from overflowing to the second region 12, and avoid impact on the strength of bonding between the molding compound and the second region 12 when the first solder overflows to the second region 12. Therefore, molding strength can be further enhanced.

It should be understood that a shape of the second region 12 may be set based on an actual situation provided that the foregoing position relationship can be met. This is not limited herein.

In addition, the second region 12 may conform to the following settings.

Setting 1: A forming material of the second region 12 may be set to be different from a forming material of the first region 11, so that the second region 12 may be used as a solder resist layer to perform a solder resist function on the first solder 41 in the first region 11, to prevent the first solder 41 from overflowing the first region 11, and avoid impact on another structure while improving a soldering effect. In addition, the substrate can be further fastened, to avoid deviation of the substrate during soldering.

Setting 2: The second region 12 is formed through sandblasting, in other words, the delimited second region 12 is bombarded in a sandblasting manner, to increase the surface roughness of the second region 12. In this way, the second region 12 may have high surface roughness, to improve a molding effect.

Setting 3: A concave-convex structure is disposed on the second region 12, and the concave-convex structure may be at least one of the following structures: a fin structure, a concave structure, and a convex structure. A specific combination manner may be set based on an actual requirement. This is not limited herein. In addition, specific shapes and disposing density of each fin, pit, and protrusion in the fin structure may be set based on an actual requirement. This is not limited herein. In this way, the concave-convex structure is disposed in the delimited second region 12, so that the bonding area that is between the molding compound 50 and the heat dissipation panel 10 and that is in the second region 12 can be further increased, and the strength of bonding between the molding compound 50 and the heat dissipation panel 10 can be further enhanced, to further improve a molding effect.

Setting 4: A manufacturing material of the soldering surface b0 of the heat dissipation panel 10 includes copper elements. In this case, the heat dissipation panel 10 may be referred to as a bare copper setting. For example, the manufacturing material of the soldering surface b0 may be monatomic copper. In this case, the heat dissipation panel 10 may be a copper plate, or a plate whose soldering surface b0 is plated with monatomic copper. Alternatively, the manufacturing material of the soldering surface b0 may be copper oxide. In this case, the heat dissipation panel 10 may be a copper oxide plate, or a plate whose soldering surface b0 is plated with copper oxide. Alternatively, the manufacturing material of the soldering surface b0 may be a copper alloy. In this case, the heat dissipation panel 10 may be a copper alloy plate, or a plate whose soldering surface b0 is plated with a copper alloy. For example, the heat dissipation panel 10 is a copper plate. After the copper plate is manufactured, surface roughness of different regions on a surface of the copper plate is different. Therefore, the first region 11 and the second region 12 may be delimited based on the surface roughness of the surface of the copper plate, so that the surface roughness of the delimited second region 12 is greater than the surface roughness of the delimited first region 11.

It should be understood that, for a setting of the second region 12, any one of the foregoing four settings may be used, or a combination of at least two of the foregoing four settings may be used, so that a bonding area that is between the molding compound 50 and the heat dissipation panel 10 and that is in the second region 12 is further increased, and strength of bonding between the molding compound 50 and the heat dissipation panel 10 is further increased, to further improve a molding effect. For example, the combination is a combination of the setting 4 and the setting 2, namely, a setting manner of combining bare copper and local sandblasting, or a combination of the setting 4 and the setting 3, namely, a setting manner of combining bare copper and a locally disposed concave-convex structure, or a combination of the setting 1 and the setting 4, namely, a setting manner of combining different forming materials and a locally disposed concave-convex structure, or the like. Specifically, the foregoing four settings may be combined based on an actual situation. Examples are not enumerated one by one.

In addition, when the heat dissipation panel 10 includes two surfaces disposed opposite to each other, one surface may be used as the soldering surface b0, and the other surface may be used as a non-soldering surface b0. In this case, the non-soldering surface b0 may be a smooth surface. Certainly, when the other surface is also used as the soldering surface b0, each of the two surfaces of the heat dissipation panel 10 is soldered to another structure. Therefore, the second regions 12 on the two surfaces may be disposed in the foregoing manner, to enhance strength of bonding between the molding compound 50 and the two surfaces, and improve a molding effect.

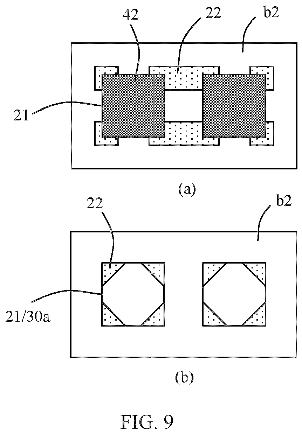

FIG. 9 to FIG. 11 are examples of diagrams of structures of a power module according to this application. As shown in FIG. 9 to FIG. 11, the structure of the power module in this embodiment is basically similar to the structure of the power module described in FIG. 2 to FIG. 8 in the foregoing embodiment, and a difference lies in that a fourth region 22 is also disposed on a second surface b2 of a substrate. Optionally, the fourth region 22 disposed at least at a corner of a third region 21 is further disposed on the second surface b2, where surface roughness of the fourth region 22 is greater than surface roughness of the third region 21, and the fourth region 22 is in contact with a molding compound. In this way, a bonding area between the molding compound and the fourth region 22 of the substrate can be increased, and strength of bonding between the molding compound and the substrate can be enhanced, to avoid delamination of bonding surfaces, and further improve a molding effect.

A position relationship between the third region 21 and the fourth region 22 may include at least one of the following relationships.

As shown in (a) and (b) in FIG. 9, when the fourth region 22 is disposed at at least a part of corners of the third region 21, and a plurality of third regions 21 are disposed, fourth regions 22 located at corner positions of two adjacent third regions 21 may be connected, as shown in (a) in FIG. 9. In this way, an area of the fourth region 22 on the surface of the substrate can be increased, and the bonding area between the molding compound and the fourth region 22 can be increased, to enhance molding strength. Certainly, the fourth regions 22 located at the corner positions of the two adjacent third regions 21 may be not connected, as shown in (b) in FIG. 9. In this way, a difficulty in manufacturing the fourth regions 22 can be reduced, and manufacturing costs of the power module can be reduced.

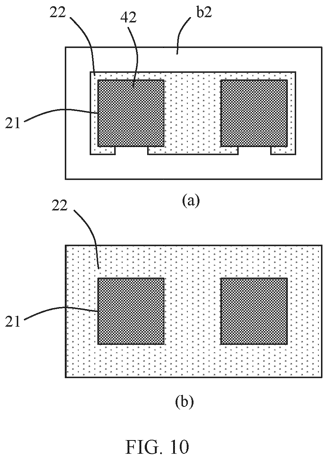

As shown in (a) in FIG. 10, when the fourth region 22 encloses a part of a peripheral region of the third region 21, and a plurality of third regions 21 are disposed, fourth regions 22 corresponding to two adjacent third regions 21 may be connected. In this way, an area of the fourth region 22 on the surface of the heat dissipation panel can be increased, and the bonding area between the molding compound and the fourth region 22 can be increased, to enhance molding strength. When the fourth regions 22 corresponding to the two adjacent third regions 21 are connected, no fourth region 22 is disposed at a part of corner positions of the two third regions 21, which is not shown in the figure. Alternatively, as shown in (a) in FIG. 10, even when the fourth region 22 encloses a part of the peripheral region of the third region 21, the fourth region 22 is disposed at each corner position of the two third regions 21. Certainly, the fourth regions 22 corresponding to the two adjacent third regions 21 may be not connected. In this way, a difficulty in manufacturing the fourth regions 22 can be reduced, and manufacturing costs of the power module can be reduced.

As shown in (b) in FIG. 10, the fourth region 22 completely encloses the peripheral region of the third region 21, and the fourth region 22 may be disposed in a part of a region except the third region 21 on the second surface b2, which is not shown in the figure. Alternatively, the fourth region 22 may be disposed in the entire region except the third region 21 on the second surface b2, as shown in (b) in FIG. 10, in other words, the region except the third region 21 on the second surface b2 is the fourth region 22. In this way, the area of the fourth region 22 can be increased to a greatest extent, and an area of contact with the molding compound can be further increased, to further enhance molding strength.

As shown in (b) in FIG. 9, the fourth region 22 overlaps an orthographic projection 30a of a chip on the substrate.

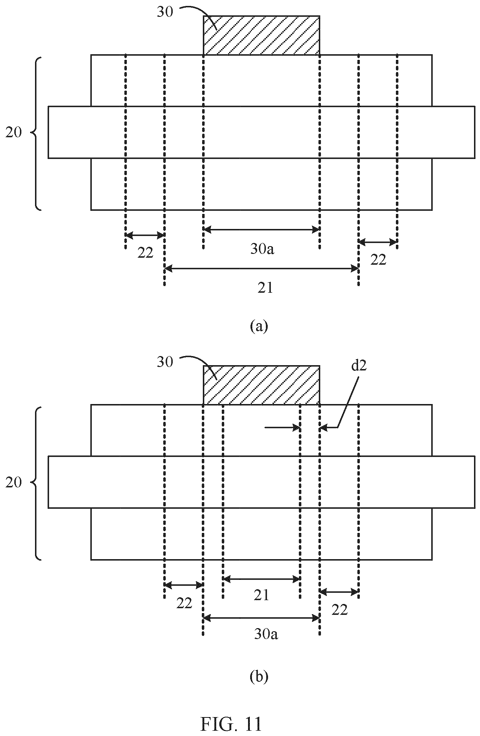

As shown in (a) in FIG. 11, the orthographic projection 30a of the chip 30 on the substrate 20 is located in the third region 21, and an area of the third region 21 is greater than an area of the orthographic projection 30a of the chip 30 on the substrate 20. In this way, because second solder (not shown in FIG. 11) is generally coated on a region soldered to the chip 30 (for example, a region indicated by 30a), and does not cover the entire third region 21, the second solder in the third region 21 with a large area is difficult to overflow, to avoid impact on strength of bonding between the molding compound and the fourth region 22 when the second solder overflows to the fourth region 22. Therefore, molding strength can be further enhanced.

As shown in (b) in FIG. 11, the third region 21 is located in the orthographic projection 30a of the chip 30 on the substrate 20, and the area of the orthographic projection 30a of the chip 30 on the substrate 20 is greater than the area of the third region 21. In this case, there is a gap d2 between the fourth region 22 and the corresponding third region 21. A size of the gap d2 may be set based on an actual requirement. The gap d2 is set to, for example, but not limited to, a distance between an edge of the third region 21 and a corresponding edge of the chip 30. In this way, when the second solder (not shown in FIG. 11) is coated on the third region 21, even if the second solder overflows, because there is a part of region (namely, a region indicated by d2) that is different from the third region 21 and that is between the chip 30 and the substrate 20, the region may be used as an overflow region, to prevent the second solder from overflowing to the fourth region 22, and avoid impact on the strength of bonding between the molding compound and the fourth region 22 when the second solder overflows to the fourth region 22. Therefore, molding strength can be further enhanced.

It should be understood that a shape of the fourth region 22 may be set based on an actual situation provided that the foregoing position relationship can be met. This is not limited herein.

In addition, the fourth region 22 may conform to the following settings.

Setting 1: A forming material of the fourth region 22 may be set to be different from a forming material of the third region 21, so that the fourth region 22 can be used as a solder resist layer to perform a solder resist function on the second solder in the third region 21, to prevent the second solder from overflowing the third region 21, and avoid impact on another structure while improving a soldering effect. In addition, the chip can be further fastened, to avoid deviation of the chip during soldering.

Setting 2: The fourth region 22 is formed through sandblasting, in other words, the delimited fourth region 22 is bombarded in a sandblasting manner, to increase the surface roughness of the fourth region 22. In this way, the fourth region 22 may have high surface roughness, to improve a molding effect.

It should be understood that, for settings of the fourth region 22, any one of the foregoing two settings may be used, or a combination of the foregoing two settings may be used, so that a bonding area that is between the molding compound and the heat dissipation panel and that is in the fourth region 22 is further increased, and the strength of bonding between the molding compound and the heat dissipation panel is further enhanced, to further improve a molding effect. In addition, in FIG. 9 to FIG. 11, 42 represents the second solder located in the third region 21.

It should be further understood that, for a similarity between the structure of the power module in this embodiment and the structure of the power module described in FIG. 2 to FIG. 8 in the foregoing embodiment, refer to related descriptions in FIG. 2 to FIG. 8 in the foregoing embodiment. Repeated content is not described again.

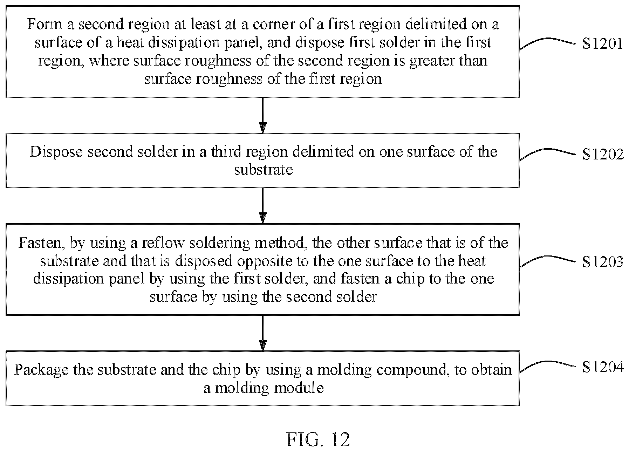

FIG. 12 is an example of a diagram of a power module manufacturing method according to this application. As shown in FIG. 12, the power module manufacturing method may include the following steps.

S1201: Form a second region at least at a corner of a first region delimited on a surface of a heat dissipation panel, and dispose first solder in the first region, where surface roughness of the second region is greater than surface roughness of the first region.

When the second region in S1201 is formed, at least one of the following manners may be used: a laser ablation manner, a mold pressing manner, a sandblasting manner, or a manner of manufacturing a concave-convex structure.

For laser ablation, a working principle of the laser ablation is as follows: The delimited second region is irradiated by using a laser, so that a series of physical phenomena such as a temperature rise, instant melting or even vaporization, and ionization mixed steam occur on a surface layer material of the second region, thereby leaving a permanent burn mark. Therefore, after the laser ablation is used, a forming material of the second region is different from a forming material of the first region, so that the second region can be used as a solder resist layer to perform a solder resist function on the first solder in the first region, to prevent the first solder from overflowing the first region, and avoid impact on another structure while improving a soldering effect. In addition, a substrate can be further fastened, to avoid deviation of the substrate during soldering. When the delimited second region is irradiated by using the laser, a plurality of ablation lines are left in the second region, and a spacing between adjacent ablation lines may be small or even zero. In this way, surface roughness at different positions in the second region can be more uniform, to improve molding reliability.

For mold pressing, the delimited second region is pressed by using a mold with a pattern, to increase the surface roughness of the second region. This manner is easy to operate and easy to implement, and can reduce manufacturing costs of the power module while improving a molding effect. During the mold pressing, the pattern in the mold may be mesh-shaped, triangle-shaped, quadrilateral-shaped, irregular-shaped, or the like, and may be designed based on an actual requirement. In addition, a pressing depth of the mold is not specifically required.

For sandblasting, a working principle of the sandblasting is as follows: Sand is sprayed to the surface of the heat dissipation panel, and the surface of the heat dissipation panel is bombarded by using the sand, to form the second region. Therefore, during the sandblasting, the surface roughness of the second region may be controlled by selecting a size of the sand, to meet a molding requirement. Further, the size of the sand may be selected based on a requirement for the surface roughness of the second region. This is not limited herein. In addition, a manufacturing material of a soldering surface of the heat dissipation panel includes copper elements. For example, the manufacturing material of the soldering surface of the heat dissipation panel may be monatomic copper. In this case, the heat dissipation panel may be a copper plate, or a plate whose soldering surface is plated with monatomic copper. Alternatively, the manufacturing material of the soldering surface of the heat dissipation panel may be copper oxide. In this case, the heat dissipation panel may be a copper oxide plate, or a plate whose soldering surface is plated with copper oxide. Alternatively, the manufacturing material of the soldering surface of the heat dissipation panel may be a copper alloy. In this case, the heat dissipation panel may be a copper alloy plate, or a plate whose soldering surface is plated with a copper alloy. In this way, the second region is formed in a manner of combining bare copper and local sandblasting. This manner is easy to operate and easy to implement, and can reduce manufacturing costs of the power module while improving a molding effect.

For manufacturing a concave-convex structure, the concave-convex structure may be at least one of the following structures: a fin structure, a concave structure, and a convex structure. A specific combination manner may be set based on an actual requirement. This is not limited herein. In addition, specific shapes and disposing density of each fin, pit, and protrusion in the fin structure may be set based on an actual requirement. This is not limited herein.

Certainly, for example, the heat dissipation panel is a copper plate. After the copper plate is manufactured, surface roughness of different regions on a surface of the copper plate is different. Therefore, the first region and the second region may be delimited based on the surface roughness of the surface of the copper plate, so that the surface roughness of the delimited second region is greater than the surface roughness of the delimited first region. Compared with using a copper plate whose surface is plated with nickel as the heat dissipation panel, in a manner of using the copper plate as the heat dissipation panel, the first region and the second region may be obtained without performing any processing on the surface of the copper plate. In this manner, manufacturing costs can be greatly reduced, production capacity can be improved, and a nickel plating process can be reduced.

In addition, a specific value of the surface roughness of the second region may be set based on a requirement for molding. For example, if the requirement for molding is high, the surface roughness of the second region may be set to a larger value. If the requirement for molding is low, the surface roughness of the second region may be set to a smaller value.

S1202: Dispose second solder in a third region delimited on one surface of the substrate.

S1203: Fasten, by using a reflow soldering method, the other surface that is of the substrate and that is disposed opposite to the one surface to the heat dissipation panel by using the first solder, and fasten the chip to the one surface by using the second solder.

The reflow soldering method is a method in which gas (for example, but not limited to nitrogen) circulates in a soldering machine to generate a high temperature, so as to achieve a soldering objective. Therefore, the chip and the substrate, and the substrate and the heat dissipation panel are soldered together at the same time.

Certainly, when another soldering method is used, the chip may be first soldered to the substrate, and then the substrate soldered to the chip may be soldered to the heat dissipation panel. Alternatively, the substrate may be first soldered to the heat dissipation panel, and then the chip is soldered to the substrate. A specific soldering sequence and a specific soldering method are not limited herein provided that soldering between the chip and the substrate and soldering between the substrate and the heat dissipation panel can be implemented.

S1204: Package the substrate and the chip by using a molding compound, to obtain the power module.

In this way, when the surface roughness of the second region is greater than the surface roughness of the first region, a bonding area between the molding compound and the second region of the heat dissipation panel can be increased, and strength of bonding between the molding compound and the heat dissipation panel can be enhanced, to avoid delamination of bonding surfaces, and improve a molding effect.

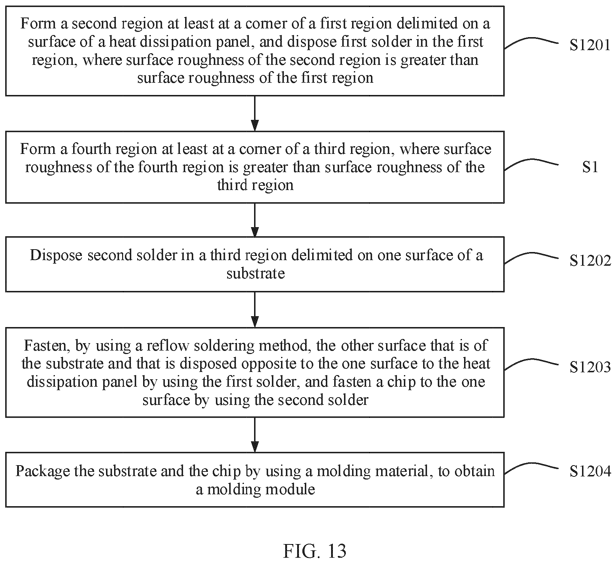

FIG. 13 is an example of a diagram of a power module manufacturing method according to this application. As shown in FIG. 13, the power module manufacturing method in this embodiment is basically similar to the power module manufacturing method in the embodiment shown in FIG. 12, and a difference lies in that step S1 is added between S1201 and S1202. Optionally, step S1 is: forming a fourth region at least at a corner of a third region, where surface roughness of the fourth region is greater than surface roughness of the third region. In this way, a bonding area between a molding compound and the fourth region of a substrate can be increased, and strength of bonding between the molding compound and the substrate can be enhanced, to avoid delamination of bonding surfaces, and further improve a molding effect.

When the fourth region in S1 is formed, at least one of the following manners may be used: a laser ablation manner, a mold pressing manner, and a sandblasting manner, and specific implementations of the laser ablation, the mold pressing, and the sandblasting are the same as specific implementations of the related method mentioned in the embodiment shown in FIG. 12. For details, refer to related descriptions in the embodiment shown in FIG. 12. Repeated content is not described again.

It should be understood that, for details of a similarity between the power module manufacturing method in this embodiment and the power module manufacturing method in the embodiment shown in FIG. 12, namely, a similarity between S1201 in FIG. 13 and S1201 in FIG. 12, a similarity between S1202 in FIG. 13 and S1202 in FIG. 12, a similarity between S1203 in FIG. 13 and S1203 in FIG. 12, or a similarity between S 1204 in FIG. 13 and S1204 in FIG. 12, refer to related descriptions in the embodiment shown in FIG. 12. Repeated content is not described again.

Clearly, persons skilled in the art can make various modifications and variations to embodiments of this application without departing from the scope of embodiments of this application. In this case, this application is intended to cover these modifications and variations of embodiments of this application provided that they fall within the scope of protection defined by the following claims of this application and their equivalent technologies.

## Claims

1. A power module, comprising a heat dissipation panel, a substrate, and a chip that are sequentially stacked, wherein
a first region and a second region are disposed on a surface of the heat dissipation panel, the second region is disposed at least at a corner of the first region, surface roughness of the second region is greater than surface roughness of the first region, and a projection of the substrate in a thickness direction of the heat dissipation panel overlaps the first region;
a third region is disposed on a surface that is of the substrate and that is away from the heat dissipation panel, and a projection of the chip in the thickness direction of the heat dissipation panel overlaps the third region; and
the substrate and the chip are packaged by using a molding compound, and the second region is in contact with the molding compound.

2. The power module according to claim 1, wherein a plurality of first regions are disposed, and at least parts of second regions corresponding to two adjacent first regions are connected.

3. The power module according to claim 1 or 2, wherein a region, except the first region, on the surface of the heat dissipation panel is the second region.

4. The power module according to any one of claims 1 to 3, wherein the second region overlaps an orthographic projection of the substrate on the heat dissipation panel.

5. The power module according to any one of claims 1 to 4, wherein the orthographic projection of the substrate on the heat dissipation panel is located in the first region, and an area of the first region is greater than an area of the orthographic projection of the substrate on the heat dissipation panel.

6. The power module according to any one of claims 1 to 4, wherein the first region is located in the orthographic projection of the substrate on the heat dissipation panel, and an area of the orthographic projection of the substrate on the heat dissipation panel is greater than an area of the first region; and
there is a gap between the second region and the corresponding first region.

7. The power module according to any one of claims 1 to 6, wherein a concave-convex structure is disposed on the second region.

8. The power module according to claim 7, wherein the concave-convex structure is at least one of the following structures: a fin structure, a concave structure, and a convex structure.

9. The power module according to any one of claims 1 to 8, wherein a fourth region is further disposed on the surface that is of the substrate and that is away from the heat dissipation panel, the fourth region is disposed at least at a corner of the third region, surface roughness of the fourth region is greater than surface roughness of the third region, and the fourth region is in contact with the molding compound.

10. The power module according to claim 9, wherein the fourth region encloses at least a part of the third region; or
the second region encloses at least a part of the first region.

11. The power module according to claim 9 or 10, wherein a region, except the third region, on the surface that is of the substrate and that is away from the heat dissipation panel is the fourth region.

12. The power module according to any one of claims 9 to 11, wherein a forming material of the fourth region is different from a forming material of the third region; or
a forming material of the second region is different from a forming material of the first region.

13. The power module according to any one of claims 9 to 12, wherein the second region or the fourth region is formed through sandblasting.

14. A method for manufacturing the power module according to any one of claims 1 to 13, comprising:
forming a second region at least at a coner of a first region on a surface of a heat dissipation panel, wherein surface roughness of the second region is greater than surface roughness of the first region;
fastening a substrate to the heat dissipation panel by using the first region, and fastening a chip to the substrate by using a third region, so that a projection of the substrate in a thickness direction of the heat dissipation panel overlaps the first region, and a projection of the chip in the thickness direction of the heat dissipation panel overlaps the third region; and
packaging the substrate and the chip by using a molding compound, so that the second region is in contact with the molding compound, to obtain the power module.

15. An electronic device, comprising a housing and the power module according to any one of claims 1 to 13, wherein the power module is disposed in the housing.
